# EUROPEAN PATENT SPECIFICATION

(11) **EP 0 622 193 B1**
(45) Date of publication and mention of the grant of the patent: **10.05.2000**
(21) Application number: 93120808.6
(22) Date of filing: 23.12.1993
(51) Int. Cl.: B41J 2/01

(54) **An improved unitary interconnect system for an inkjet printer**
Ein verbessertes einheitliches Verbindungssystem für einen Tintenstrahldrucker
Un système d'interconnexion unitaire perfectionné pour une imprimante à jet d'encre

(30) Priority: 30.04.1993 US 55615
(43) Date of publication of application: 02.11.1994
(73) Proprietor: Hewlett-Packard Company, Palo Alto, California 94304 (US)
(72) Inventor: Wilson, Arthur King, San Diego, CA 92124 (US); Brown, Patricia Susan, Encinitas, CA 92024 (US)
(74) Representative: Schoppe, Fritz, Dipl.-Ing.

(56) References cited:
- EP-A- 0 492 955
- US-A- 3 113 248
- US-A- 4 775 868
- US-A- 4 872 027
- US-A- 5 162 818

## Description

This invention relates to interconnect systems and more particularly to interconnect systems for multiple inkjet pens in an inkjet printer.

While the present invention is described herein with reference to illustrative embodiments for particular applications, it should be understood that the invention is not limited thereto. Those having ordinary skill in the art and access to the teachings provided herein will recognize additional modifications, applications, and embodiments within the scope thereof and additional fields in which the present invention would be of significant utility.

Inkjet printer/plotters and desktop printers, such as those sold by Hewlett Packard Company, offer substantial improvements in speed over the conventional X-Y plotter. Inkjet printer/plotters typically include a pen having an array of nozzles. The pens are mounted on a carriage which is moved across the page in successive swaths. Each inkjet pen has heater circuits which, when activated, cause ink to be ejected from associated nozzles. As the pen is positioned over a given location, a jet of ink is ejected from the nozzle to provide a pixel of ink at a desired location. The mosaic of pixels thus created provides a desired composite image.

Inkjet technology is now well known in the art. See, for example, U. S. Patents Nos. 4,872,027, entitled PRINTER HAVING IDENTIFIABLE INTERCHANGEABLE HEADS, issued October 3, 1989, to W. A. Buskirk et al. and 4,965,593, entitled PRINT QUALITY OF DOT PRINTERS, issued October 23, 1990, to M. S. Hickman.

Recently, full color inkjet printer/plotters and desktop printers have been developed which comprise a plurality of inkjet pens of diverse colors. A typical color inkjet printer/plotter has four inkjet pens, one that stores black ink, and three that store colored inks, e.g., magenta, cyan and yellow. The colors from the three color pens are mixed to obtain any particular color.

The pens are typically mounted in stalls within an assembly which is mounted on the carriage of the printer/plotter. The carriage assembly positions the inkjet pens and typically holds the circuitry required for interfacing to the heater circuits in the inkjet pens.

Conventionally, a carriage assembly consists of four pen stalls to align the inkjet pens, four pen clamps to hold the inkjet pens in the pen stalls, a printed circuit board having the circuitry for interfacing to the heater circuits in the inkjet pens, and four separate flexible circuits interconnected between the printed circuit board and electrical contacts on the inkjet pens. Each of these separate parts are conventionally assembled piece by piece with screws fastening the parts individually to a housing to form a carriage assembly. Assembly of these individual parts is a difficult and expensive process and special tools are required to properly align the parts.

The carriage assembly moves during printing and for quick responsiveness, it is required that the overall carriage assembly be lightweight, which results in a relatively fragile carriage assembly. If a conventional carriage assembly is accidentally bumped or one of its components fails, then repair for a conventional carriage assembly is costly, because of the multitude of individual parts and the difficult alignment process.

Conventionally, in a carriage assembly, a separate flexible circuit is used to interconnect each inkjet pen to the associated printed circuit board. The flexible circuit is made with a polyester or polyimid material such as a Mylar or Kapton substrate onto which multiple conductors are deposited. A color inkjet printer with four inkjet pens requires four separate flexible circuits.

The use of four separate flexible circuits has the disadvantages of: 1) high cost, due to the need to manufacture and stock the multiple separate flexible circuits; 2) difficulty of assembly, because of the need to route in the carriage assembly and precisely align each of the separate flexible circuits to each of the pen housings; 3) cost of assembly because the separate flexible circuits need to be separately interconnected with the printed circuit board; and 4) the need to provide separate grounds for each separate flexible circuit.

There is limited interconnect area for grounds, so having separate grounds for each flexible circuit limits the number of ground interconnects available for an inkjet pen. Separate grounds for each flexible circuit prevents sharing of a common ground plane for all the inkjet pens, which would be advantageous, because ground plane sharing assists in maintaining all the heater circuits in the inkjet pens at the proper ground potential regardless of which heater circuits are activated. In a conventional device there are separate ground returns for each inkjet pen, which can cause ground fluctuations and inkjet pen performance degradation, if a large number of heater circuits in one inkjet pen are activated.

Other conventional approaches to inkjet electrical interconnect include the use of edge connectors that have the disadvantages of high cost and low interconnect density.

It is the object of the present invention to provide an improved interconnect system that reduces cost, is easier to assemble and align, and provides ground plane sharing for all of the inkjet pens.

This object is achieved by an interconnect system according to claim 1.

The present invention provides an improved unitary interconnect system for an inkjet printer of the present invention. The system includes a first inkjet pen having a first electrical contact and a second inkjet pen having a second electrical contact. The improvement includes a substrate, a third electrical contact on the substrate coupled to the first electrical contact on the first inkjet pen, a fourth electrical contact on the substrate coupled to the second electrical contact on the second inkjet pen, and a conductive layer deposited on the substrate electrically interconnecting the third electrical contact to the fourth electrical contact.

In a specific embodiment an improved unitary interconnect system for a inkjet printer includes a first inkjet pen having a first electrical contact, a second inkjet pen having a second electrical contact, a substrate having a first end and a second end, a first plurality of electrical contacts on the substrate near the first end of the substrate coupled to the first inkjet pen, a second plurality of electrical contacts on the substrate near the first end of the substrate coupled to the second inkjet pen, a third plurality of electrical contacts on the substrate near the second end of the substrate, and a conductive layer deposited on the substrate and electrically interconnecting the first plurality of electrical contacts to the second plurality of electrical contacts and to the third plurality of electrical contacts. The number of electrical contacts in the first plurality of electrical contacts and the second plurality of electrical contacts is greater than the number of electrical contacts in the third plurality of electrical contacts.

The improved unitary interconnect system provides an interconnect system that reduces cost, is easier to assemble and align, and provides ground plane sharing for all of the inkjet pens.
FIGs. 1a through 1c are illustrative diagrams showing an inkjet printer, inkjet pen and inkjet pens installed in a unitary housing in accordance with the present invention.
FIGs. 2a and 2b are illustrative diagrams showing spring mechanisms for clamping the inkjet pens in a unitary housing in accordance with the present invention.
FIGs. 3a through 3c are illustrative diagrams of an improved carriage assembly showing the coupling of a removable frame circuit assembly to a unitary housing in accordance with the present invention.
FIG. 4 is an illustrative diagram showing a unitary housing in accordance with the present invention.
FIGs. 5a and 5b are illustrative diagrams showing the assembly of a unitary frame with a circuit board and unitary interconnect to form a removable frame circuit assembly in accordance with the present invention.
FIGs. 6a and 6b are illustrative diagrams showing the assembly of a unitary interconnect on a unitary frame with a circuit board to form a removable frame circuit assembly in accordance with the present invention.
FIG. 7 is an illustrative diagram of a unitary interconnect system constructed in accordance with the present invention.
FIG. 8 is an illustrative diagram of section 8-8 of FIG. 7 showing protrusions on the unitary interconnect system for electrical signal and electrical ground contacts constructed in accordance with the present invention.
FIG. 9 is an illustrative diagram of section 9-9 of FIG. 7 showing protrusions on the unitary interconnect system for electrical signal and electrical ground contacts constructed in accordance with the present invention.
FIG. 10 is an illustrative diagram of a disassembled improved electrical interconnect system for a unitary interconnect in accordance with the present invention.
FIG. 11 is an illustrative diagram showing contacts on a circuit board corresponding to contacts on a unitary interconnect constructed in accordance with the present invention.
FIG. 12 is an illustrative diagram of an elevation section along line 12-12 of FIG. 10 of an assembled improved electrical interconnect system for a unitary interconnect constructed in accordance with the present invention.

Illustrative embodiments and exemplary applications will now be described with reference to the accompanying drawings to disclose the advantageous teachings of the present invention.

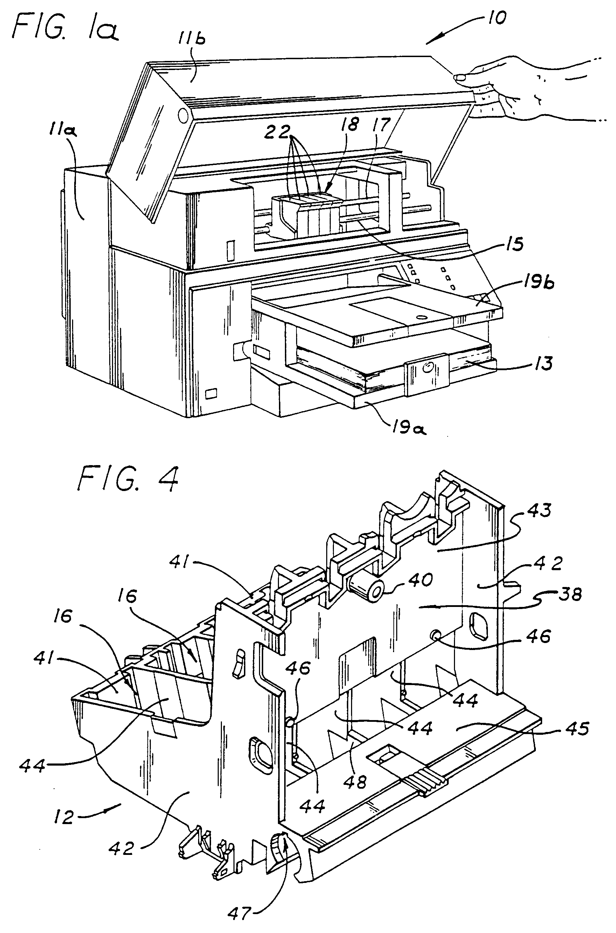

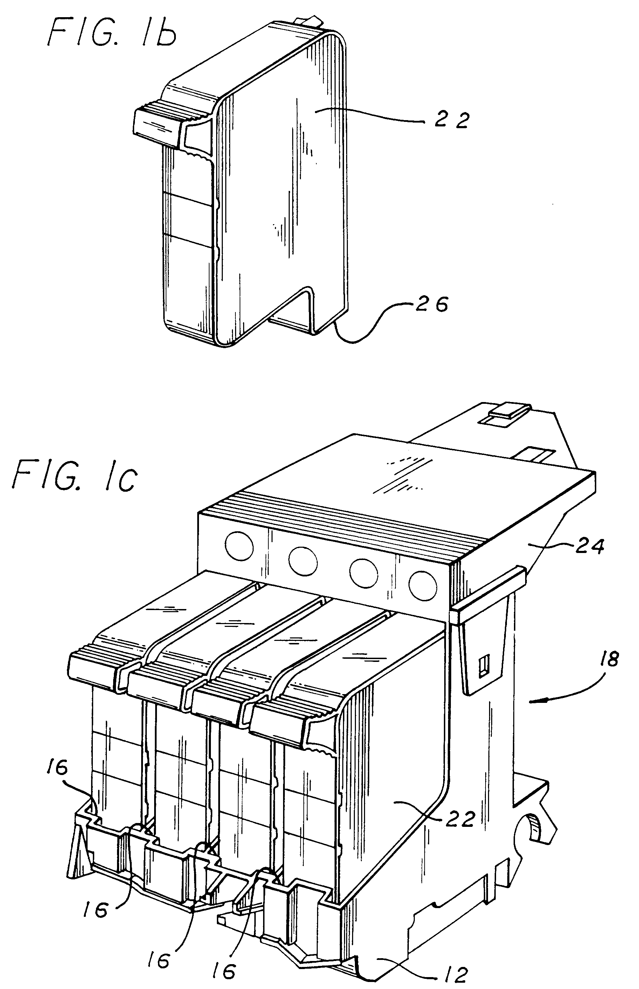

Fig. 1 is a perspective view of a thermal inkjet desktop printer incorporating the teachings of the present invention. The printer **10** includes a housing **11a** and a protective front access lid **11b**. A carriage assembly **18**, which has four inkjet pens **22**, is adapted for reciprocal motion along carriage bar **15**. The position of the carriage assembly **18** in the carriage scan axis along carriage bar **15** is determined by a carriage positioning mechanism (not shown) on the carriage assembly **18** that senses its position relative to carriage encoder strip **17**. An input tray **19a** holds an media input stack **13** and after printing the printed media is held by an output tray **19b**.

A color inkjet printer/plotter has four inkjet pens **22**, one that stores black ink, and three that store colored inks, e.g., magenta, cyan and yellow. The colors from the three color pens are mixed to obtain any particular color. FIG. 1b is a detailed illustration of an inkjet pen **22** that includes heater circuits, which when activated cause ink to be ejected from the inkjet pen **22** at end **26**. FIG. 1c illustrates carriage assembly **18** including four inkjet pens **22** installed in four pen stalls **16** in unitary housing **12** with cover **24** placed on top.

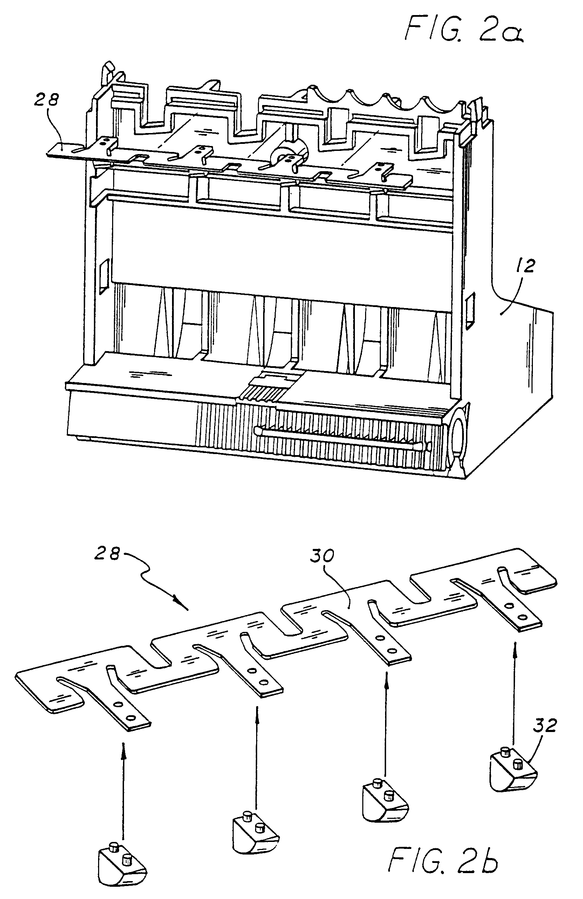

The inkjet pens **22** are held in unitary housing **12** by unitary spring clamp assembly **28**, which is installed onto unitary housing **12**, as shown in FIG. 2a. The tops of the inkjet pens **22** are retained by cam clamps **32** on unitary spring clamp assembly **28** when the inkjet pens **22** are inserted into unitary housing **12**. FIG. 2b shows the position of cam clamps **32** on spring **30** to form unitary spring clamp assembly **28**.

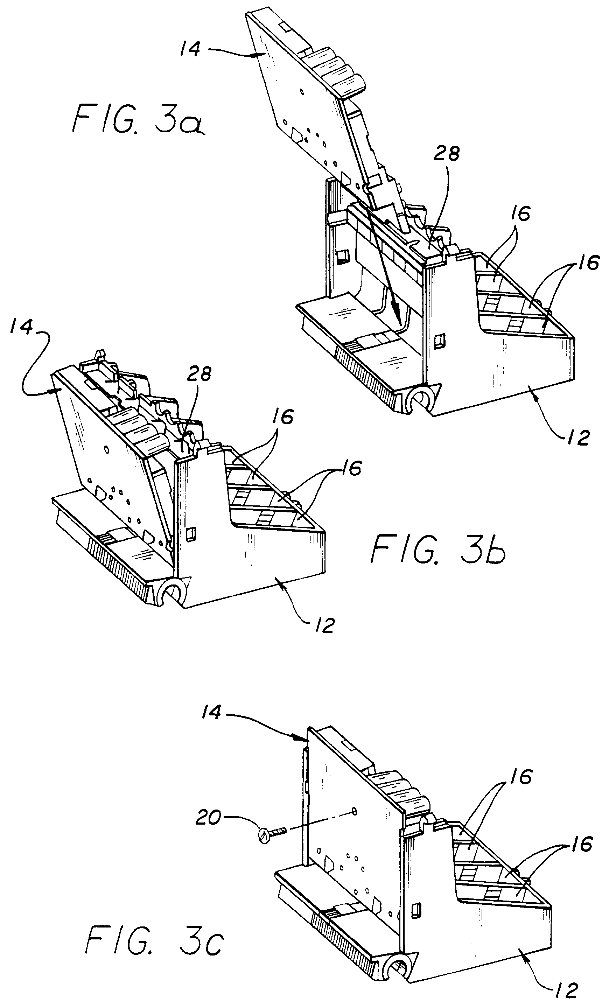

After unitary clamp assembly **28** is installed onto unitary housing **12**, as shown in FIG. 2a, then removable frame circuit assembly **14** is placed into unitary housing **12**, as shown in FIGs. 3a and 3b. Removable frame circuit assembly **14** is fastened to unitary housing **12** with a single attachment device **20**, as shown in FIG 3c.

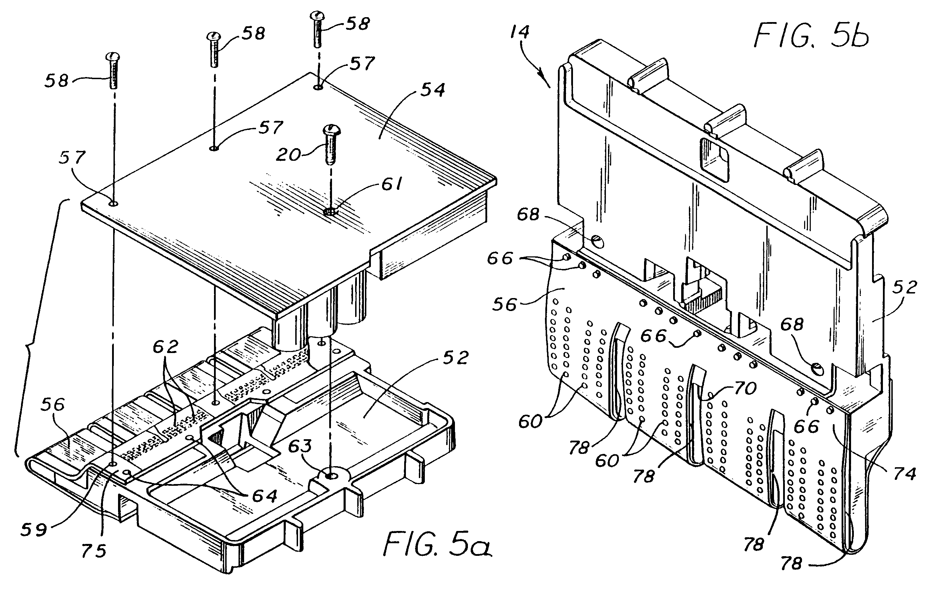

FIG. 4 is an illustrative diagram showing a detailed view of the unitary housing **12** in accordance with the present invention. The unitary housing **12** is a one piece construction and retains the inkjet pens in a fixed relation to each other and the inkjet printer. A first portion **47** integral to the unitary housing extends along a first axis and is adapted to engage the carriage bar **15**. The pen stalls **16** each extend along a second axis and are substantially transverse to and integral with the first portion **47**. Rear compartment **38**, extending along a third axis, is substantially transverse to and integral with the first and second portions and adapted to retain a substantially planar frame circuit assembly **14** within a plane defined by the first and third axes. The unitary housing provides a substantially smaller carriage assembly than the prior art.

The unitary housing **12** has a front wall **41**, two lateral walls **42**, three pen stall walls **44**, and rear wall **43**, which form four pen stalls **16**. It also has a rear compartment **38** formed by lateral walls **42**, rear wall **43**, base **45**, and the spaces between pen stall walls **44** closest to base **45**. The four pen stalls **16** have passages that communicate to the rear stall between rear wall **43** and base **45** and between the pen stall walls **44**. The removable frame circuit assembly **14** is installed into the rear compartment **38** in unitary housing **12**, as shown in FIGs. 3a - 3c. The single attachment device **20**, which can be a simple screw, mates with single attachment point **40** on unitary housing **12** to attach removable frame circuit assembly **14** to unitary housing **12**.

The removable frame circuit assembly **14** needs to be properly aligned to the unitary housing **12**, because there are electrical contacts on the inkjet pens that when mounted in pen stalls **16** must make proper electrical contact with electrical contacts on the removable frame circuit assembly **14**. The alignment of removable frame circuit assembly **14** to unitary housing **12** is provided by two vertical alignment pins **46** for vertical alignment and by single horizontal alignment wall **48** for horizontal alignment. The vertical alignment pins **46** mate with alignment holes **68** on removable frame circuit assembly **14**, shown in FIG. 5b. The single horizontal alignment wall **48** is a vertical wall in unitary housing **12**. Alignment slot **70** on removable frame circuit assembly **14**, shown in FIG. 5b, slides over and aligns to single horizontal alignment wall **48** when the removable frame circuit assembly **14** is assembled with unitary housing **12**.

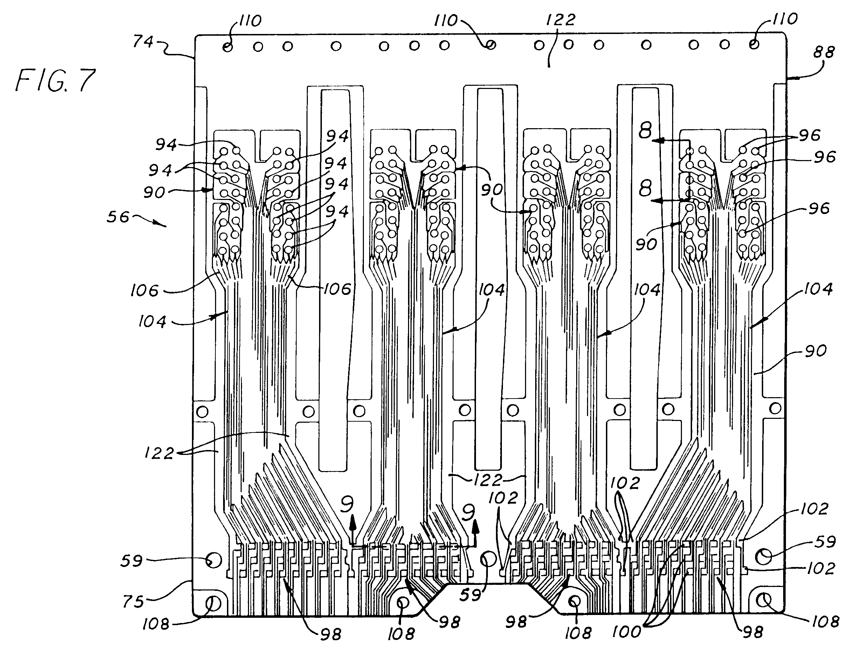

FIGs. 5a and 5b are illustrative diagrams showing the assembly of a unitary frame **52** with circuit board **54** and unitary interconnect **56** to form removable frame circuit assembly **14** in accordance with the present invention. The unitary interconnect **56** is aligned to unitary frame **52** by alignment pins **64** and unitary interconnect alignment pins **66** on unitary frame **52** that fit into alignment holes **108** and alignment holes **110**, respectively, on unitary interconnect **56** as shown in FIG. 7. The unitary interconnect **56** is wrapped over extensions **78** that are on one end of unitary frame **52**. When the frame circuit assembly **14** is installed into unitary housing **12**, then extensions **78** slide into the passages between pen stall walls **44** and rear wall **43** and behind base **45**, which positions electrical contacts **60** for interconnection with electrical contacts on the inkjet pens **22**.

The unitary interconnect **56** provides a shorter interconnect between the inkjet pens **22** and the circuit board **54** than the separate flexible circuits for each inkjet pen of the prior art, which is partially a result of the substantially smaller carriage assembly provided by unitary housing **12**.

The unitary interconnect **56** has two areas of electrical contacts: electrical contacts **60** on unitary interconnect first end **74** and electrical contacts **62** on unitary interconnect second end **75**. The electrical contacts **62** interconnect with circuit board **54**. The electrical contacts **60** are for electrical interconnection with the inkjet pens **22** held in pen stalls **16**. As shown in FIG. 5a, the circuit board **54** is attached to the unitary frame **52** with devices such as screws **58** that pass through circuit board attachment holes **57** and unitary interconnect holes **59** and into unitary frame **52**. The single attachment device **20** passes through circuit board attachment hole **61** and unitary frame hole **63**, when attaching removable frame circuit assembly **14** to unitary housing **12**.

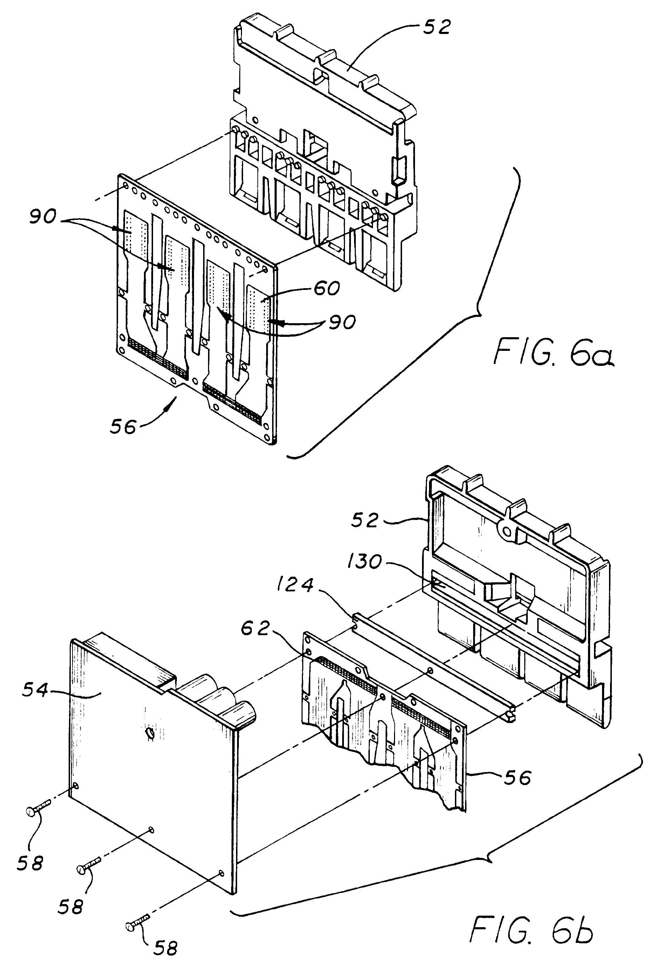

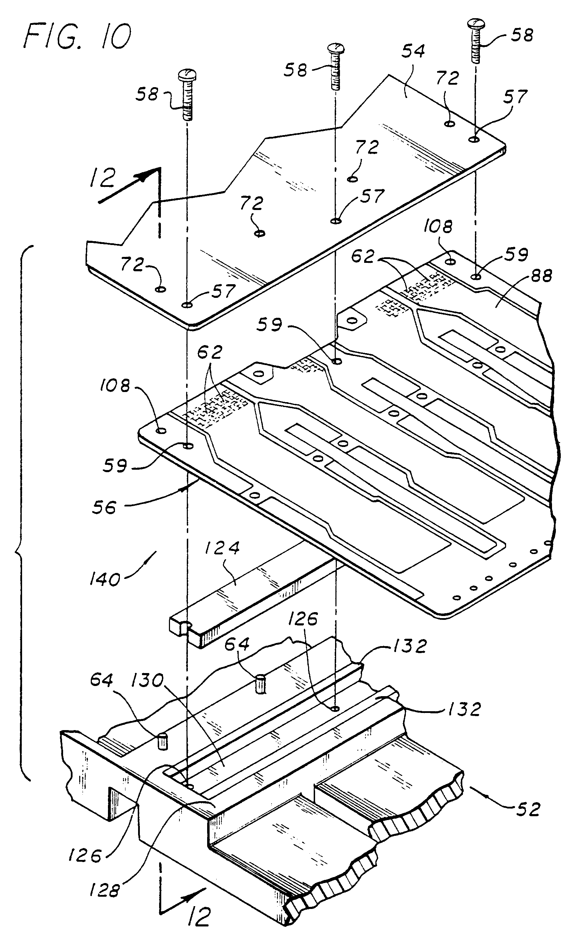

FIGs. 6a and 6b are illustrative diagrams showing the assembly of unitary interconnect **56** on unitary frame **52** and circuit board **54** to form a removable frame circuit assembly **14** in accordance with the present invention. As shown in FIG. 6a, the unitary interconnect **56** is first aligned and attached to unitary frame **52**. Then, as shown in FIG. 6b, an elastomeric pad **124** is placed into recess **130** in unitary frame **52** and then the unitary interconnect **56** is wrapped over one end of unitary frame **52** and the electrical contacts **62** are aligned onto unitary frame **52** and over the elastomeric pad **124**. Finally, the circuit board **54** is attached to the unitary frame **52** to make electrical contact with electrical contacts **62** on unitary interconnect **56**. The electrical interconnection of the unitary interconnect **56** with the circuit board **54** is described in further detail with reference to FIG. 10 later in this specification.

FIG. 7 is an illustrative detailed diagram of the unitary interconnect **56** constructed in accordance with the present invention. The unitary interconnect **56** includes substrate **88**, which for convenience of description has a unitary interconnect first end **74** and a unitary interconnect second end **75**. As discussed above, there are alignment holes **108** and alignment holes **110** on substrate **88** for alignment to the unitary frame **52**.

Along unitary interconnect first end **74** of substrate **88**, there are four identical individual sets of electrical signal and ground contacts **90** that are for interconnection to the signal contacts on an inkjet pen. Each identical individual set of electrical signal and ground contacts **90** in FIG. 7 has twenty three electrical signal contacts **94** and nine electrical ground contacts **96**. The electrical contacts **60** of FIG. 5b are simplified representations of the electrical signal contacts **94** and electrical ground contacts **96**, as shown more accurately in FIG. 7.

At unitary substrate second end **75** of substrate **88**, there are four individual sets of electrical signal contacts **98**, which each have twenty three electrical signal contacts **100**. The four individual sets of electrical traces **104**, which each include twenty three electrical traces **106**, interconnect the twenty three electrical signal contacts **94** of each of the identical individual sets of electrical signal and ground contacts **90** to the individual sets of electrical signal contacts **98**. There are sixteen total electrical ground contacts **102** along the unitary interconnect second end **75** of substrate **88**. The electrical contacts **62** of FIG. 5a are simplified representations of the electrical signal contacts **100** and electrical ground contacts **102**, as shown more accurately in FIG. 7.

In an inkjet printer the number of heater circuits that are activated at any one time are determined by the pattern being printed. The advantage of the design for unitary interconnect **56** is that a common conductive ground layer **122** is used to interconnect the nine electrical ground contacts **96** for each of the four identical individual sets of electrical signal and ground contacts **90** to all sixteen electrical ground contacts **102**. Thus, a total of thirty six electrical ground contacts **96** are interconnected via common conductive ground layer **122** with sixteen electrical ground contacts **102**. This solves the problem of having limited interconnect area at unitary interconnect second end **75** for the electrical ground contacts **102** and allows sharing of all the electrical ground contacts **102** for the electrical ground contacts **96** of all of the inkjet pens. Thus, if a large number of heater circuits in one inkjet pen **22** are activated, then that inkjet pen can use all sixteen electrical ground contacts **102** for a ground return. Sharing the ground contacts reduces ground fluctuations for the inkjet pens and improves their performance. In a conventional device there is a separate interconnect flexible circuit for each inkjet pen **22** and therefore separate ground returns for each inkjet pen. Thus, in the conventional device each inkjet pen has a reduced number of electrical ground contacts, which can cause ground fluctuations if a large number of heater circuits are activated in one inkjet pen.

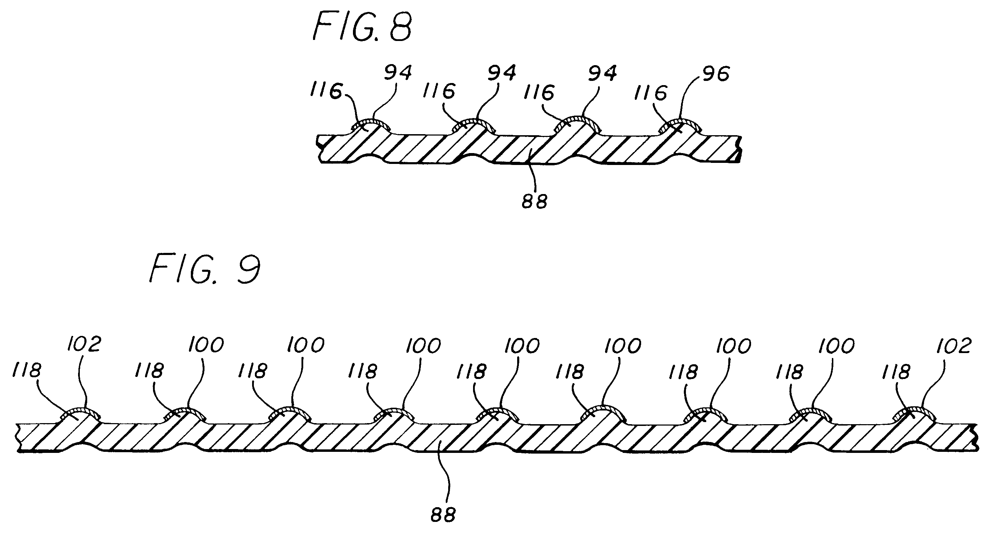

FIG. 8 is an illustrative diagram of section 8-8 of FIG. 7 showing protrusions **116** on substrate **88** constructed in accordance with the present invention. As shown in FIG. 8, there are electrical signal contacts **94** or electrical ground contacts **96** on protrusions **116**. Similarly, FIG. 9 is an illustrative diagram of section 9-9 of FIG. 7 showing protrusions **118** on substrate **88**. As shown in FIG. 9, there are electrical signal contacts **100** or electrical ground contacts **102** on protrusions **118**. The electrical contacts on protrusions **116** make contact with electrical contacts on the inkjet pens **22** and the electrical contacts on protrusions **118** make contact with electrical contacts on circuit board **54**.

In FIG. 10 an improved electrical interconnect system **140** for a flexible circuit with a circuit board is shown. The unitary interconnect **56**, shown in detail in FIG. 7, is constructed with a polyester or polyimide material such as Mylar or Kapton substrate **88** onto which multiple conductors are deposited. The conductors are made of copper and can be covered with another layer of Mylar or Kapton. Electrical contacts **62** are located on protrusions **118** on substrate **88**, as shown in FIG. 9.

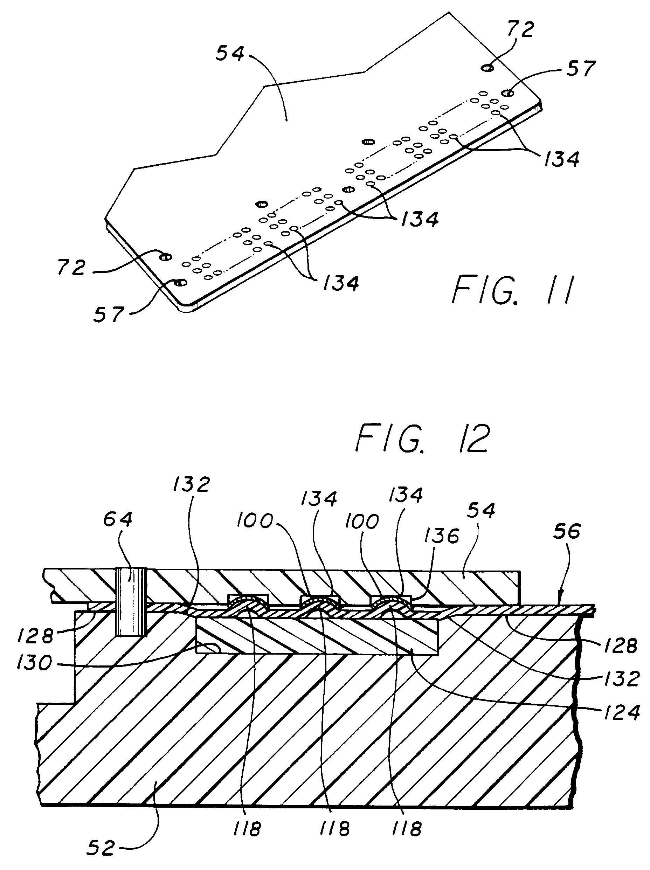

FIG. 11 shows the opposite side of circuit board **54** with circuit board contacts **134**, which according to the present invention are interconnected with electrical contacts **62** on unitary interconnect **56**. The arrangement of circuit board contacts **134** on circuit board **54** correspond to the arrangement of electrical contacts **62** on unitary interconnect **56**, which is shown in detail in FIG. 7. Each of the circuit board contacts **134** are gold plated and the electrical contacts **62** are also gold plated to insure a low resistance electrical path.

As shown in FIG. 10, the circuit board **54** and unitary interconnect **56** are assembled on a unitary frame **52**, which can be constructed of plastic, because only low pressure is used to interconnect circuit board contacts **134** and electrical contacts **62**. An elastomeric pad **124**, which can be constructed of urethane rubber, provides a spring function and is mounted into recess **130** in unitary frame **52**. The improved electrical interconnect system **140** is assembled by using screws **58** that are inserted through circuit board attachment hole **57** on circuit board **54** and unitary interconnect holes **59** on unitary interconnect **56** and then screwed into attachment holes **126** on unitary frame **52**. The electrical contacts **62** on unitary interconnect **56** are aligned to circuit board contacts **134** on circuit board **54** by alignment pins **64** coupled to unitary frame **52**, which are inserted through alignment holes **108** on unitary interconnect **56** and alignment holes **72** on circuit board **54**. When the improved electrical interconnect system is assembled the electrical contacts **62** are aligned and have electrical contact with circuit board contacts **134**.

FIG. 12 is an illustrative diagram of an elevation section along line 12-12 of FIG. 10 of an assembled improved electrical interconnect system for a flexible circuit constructed in accordance with the present invention. In FIG. 12 the elastomeric pad **124** is shown to fit within recess **130** in unitary frame **52**. The elastomeric pad **124** provides a spring function that bears upon the electrical contacts **100** on protrusions **118** between the elastomeric pad **124** and the circuit board **54**. The unitary frame **52** has bevels **132** between the recess **130** and the top surface **128** of the unitary frame **52**. The object of each bevel **132** is to provide relief for allowing the unitary interconnect **56** to deform during assembly so that all of the electrical contacts **100** on protrusions **118** make contact with all of the circuit board contacts **134** on circuit board **54**. As the screws **58** are tightened, a portion of the unitary interconnect **56** is clamped between the top surface **128** of unitary frame **52** and the circuit board **54**. Bevels **132** provide relief to the portion of unitary interconnect **56** between elastomeric pad **124** and circuit board **54**.

Also shown in FIG. 12 are circuit contact recesses **136**, which contain circuit board contacts **134**. The circuit contact recesses **136** on circuit board **54** are the result of a coating such as a solder mask that is applied over the conductors on circuit board **54** to protect the conductors from corrosion and to prevent solder bridging. This leaves slight circuit contact recesses **136** on the order of 0,00254 - 0,00508 cm (.001 - .002 inches) deep at each of the circuit board contacts **134**, which as discussed above are gold plated. During assembly, the portion of unitary interconnect **56** between elastomeric pad **124** and circuit board **54** deforms, which allows the protrusions **118** on unitary interconnect **56** to align with the circuit contact recesses **136** on circuit board **54** to ensure proper electrical contact.

The improved electrical interconnect system for a flexible circuit **140** is easy to assemble and disassemble by simply loosening or tightening screws **58**. The interconnect density exceeds 23,25 contacts per cm² (150 contacts per square inch), which provides a high density interconnect system. These desirable features are obtained while maintaining low cost and high reliability.

The improved unitary interconnect system provides an interconnect system that reduces cost, is easier to assemble and align, and provides ground plane sharing for all of the inkjet pens.

The improved carriage assembly has reduced cost and is easier to assemble, align and service without the need for any special tools.

Thus, the present invention has been described herein with reference to a particular embodiment for a particular application. Nonetheless, those having ordinary skill in the art and access to present teachings will recognize additional modifications, applications, and embodiments within the scope thereof. For example, the alignment pins of the present invention may be replaced by other equivalent devices without departing from the scope of the present invention.

## Claims

1. Interconnect system for an inkjet printer (10), the system comprising a first inkjet pen (22) having a first electrical contact, a second inkjet pen (22) having a second electrical contact,
a substrate (88); and
a third electrical contact (96) on the substrate (89) being in contact with the first electrical contact on the first inkjet pen (22);
characterized by
a fourth electrical contact (96) on the substrate (89) being in contact with the second electrical contact on the second inkjet pen (22); and
a conductive layer (122) deposited on the substrate (88) electrically interconnecting the third electrical contact (96) to the fourth electrical contact (96).

2. The interconnect system of claim 1 further characterized by:
a fifth electrical contact (102) on the substrate (88) being in contact with the conductive layer (122);
wherein the third electrical contact (96) is near a first end (74) of the substrate (88);
wherein the fourth electrical contact (96) is near the first end (74) of the substrate (88); and
wherein the fifth electrical contact (102) is near a second end (75) of the substrate (88).

3. The interconnect system of claim 2 wherein the third, fourth and fifth electrical contact are each further characterized by:
a protrusion (118) on the substrate (88); and
gold deposited on the protrusion (118).

4. The interconnect system of claim 3 is further characterized by:
a first plurality of electrical contacts (96) on the substrate (88) near the first end (74) of the substrate (88) being in contact with electrical contacts on the first inkjet pen (22);
a second plurality of electrical contacts (96) on the substrate (88) near the first end (74) of the substrate (88) being in contact with electrical contacts on the second inkjet pen (22);
a third plurality of electrical contacts (102) on the substrate (88) near the second end (75) of the substrate (88); and
wherein said conductive layer (122) deposited on the substrate (88) electrically interconnects the first plurality of electrical contacts (96) to the second plurality of electrical contacts (96) and to the third plurality of electrical contacts (102);
wherein a first number of electrical contacts in the first plurality of electrical contacts (96) and the second plurality of electrical contacts (96) is greater than a second number of electrical contacts in the third plurality of electrical contacts (102).

## Patentansprüche

1. Verbindungssystem für einen Tintenstrahldrucker (10), wobei das System folgende Merkmale aufweist:
einen ersten Tintenstrahlstift (22) mit einem ersten elektrischen Kontakt;
einen zweiten Tintenstrahlstift (22) mit einem zweiten elektrischen Kontakt;
ein Substrat (88); und
einen dritten elektrischen Kontakt (96) auf dem Substrat (88), der in Kontakt mit dem ersten elektrischen Kontakt auf dem ersten Tintenstrahlstift (22) ist;
gekennzeichnet durch
einen vierten elektrischen Kontakt (96) auf dem Substrat (88), der in Kontakt mit dem zweiten elektrischen Kontakt auf dem zweiten Tintenstrahlstift (22) ist; und
eine leitfähige Schicht (122), die auf das Substrat (88) aufgebracht ist, die den dritten elektrischen Kontakt (96) mit dem vierten elektrischen Kontakt (96) elektrisch verbindet.

2. Das Verbindungssystem gemäß Anspruch 1, ferner gekennzeichnet durch:
einen fünften elektrischen Kontakt (102) auf dem Substrat (88), der in Kontakt mit der leitfähigen Schicht (122) ist;
wobei der dritte elektrische Kontakt (96) in der Nähe eines ersten Endes (74) des Substrats (88) ist;
wobei der vierte elektrische Kontakt (96) in der Nähe des ersten Endes (74) des Substrats (88) ist; und
wobei der fünfte elektrische Kontakt (102) in der Nähe eines zweiten Endes (75) des Substrats (88) ist.

3. Das Verbindungssystem gemäß Anspruch 2, bei dem der dritte, der vierte und der fünfte elektrische Kontakt ferner gekennzeichnet sind durch:
einen Vorsprung (118) auf dem Substrat (88); und
Gold, das auf den Vorsprung (118) aufgebracht ist.

4. Das Verbindungssystem gemäß Anspruch 3, ferner gekennzeichnet durch:
eine erste Mehrzahl von elektrischen Kontakten (96) auf dem Substrat (88) in der Nähe des ersten Endes (74) des Substrats (88), die in Kontakt mit elektrischen Kontakten auf dem ersten Tintenstrahlstift (22) sind;
eine zweite Mehrzahl von elektrischen Kontakten (96) auf dem Substrat (88) in der Nähe des ersten Endes (74) des Substrats (88), die in Kontakt mit elektrischen Kontakten auf dem zweiten Tintenstrahlstift (22) sind;
eine dritte Mehrzahl von elektrischen Kontakten (102) auf dem Substrat (88) in der Nähe des zweiten Endes (75) des Substrats (88); und
wobei die leitfähige Schicht (122), die auf das Substrat (88) aufgebracht ist, die erste Mehrzahl von elektrischen Kontakten (96) mit der zweiten Mehrzahl von elektrischen Kontakten (96) und der dritten Mehrzahl von elektrischen Kontakten (102) elektrisch verbindet;
wobei eine erste Anzahl von elektrischen Kontakten der ersten Mehrzahl von elektrischen Kontakten (96) und der zweiten Mehrzahl von elektrischen Kontakten (96) größer ist als eine zweite Anzahl von elektrischen Kontakten der dritten Mehrzahl von elektrischen Kontakten (102).

## Revendications

1. Système d'interconnexion pour une imprimante à jet d'encre (10), le système comprenant une première plume à jet d'encre (22) qui possède un premier contact électrique, et une deuxième plume à jet d'encre (22) qui possède un deuxième contact électrique,
un substrat (88) ; et un troisième contact électrique (96) prévu sur le
substrat (89) et qui est en contact avec le premier contact électrique prévu sur la première plume à jet d'encre (22) ;
caractérisé par
un quatrième contact électrique (96) prévu sur le substrat (89) et qui est en contact avec le deuxième contact électrique prévu sur la deuxième plume à jet d'encre (22) ; et
une couche conductrice (122) déposée sur le substrat (88) et qui interconnecte électriquement le troisième contact électrique (96) avec le quatrième contact électrique (96).

2. Système d'interconnexion selon la revendication 1, caractérisé par
un cinquième contact électrique (102) prévu sur le substrat (88) et qui est en contact avec la couche conductrice (122),
dans lequel le troisième contact électrique (96) est proche d'une première extrémité (74) du substrat (88) ;
dans lequel le quatrième contact électrique (96) est proche de la première extrémité (74) du substrat (88) ; et
dans lequel le cinquième contact électrique (102) est proche d'une deuxième extrémité (75) du substrat (88).

3. Système d'interconnexion selon la revendication 2, dans lequel le troisième, le quatrième et le cinquième contacts électriques sont en outre caractérisés chacun par : une saillie (118) prévue sur le substrat (88) ; et de l'or déposé sur la saillie (118).

4. Système d'interconnexion selon la revendication 3, caractérisé en outre par :
une première pluralité de contacts électriques (96) prévus sur le substrat (88) près de la première extrémité (74) du substrat (88) et qui sont en contact avec des contacts électriques prévus sur la première plume à jet d'encre (22) ;
une deuxième pluralité de contacts électriques (96) prévus sur le substrat (88) près de la première extrémité (74) du substrat (88) et qui sont en contact avec des contacts électriques prévus sur la deuxième plume à jet d'encre (22) ;
une troisième pluralité de contacts électriques (102) prévus sur le substrat (88) près de la deuxième extrémité (75) du substrat (88) ; et
dans lequel ladite couche conductrice (122) déposée sur le substrat (88) interconnecte électriquement la première pluralité de contacts électriques (96) avec la deuxième pluralité de contacts électriques (96) et avec la troisième pluralité de contacts électriques (102) ;
dans lequel un premier nombre de contacts électriques compris dans la première pluralité de contacts électriques (96) et dans la deuxième pluralité de contacts électriques (96) est plus grand qu'un deuxième nombre de contacts électriques compris dans la troisième pluralité de contacts électriques (102).
